(19) Europäisches Patentamt
European Patent Office
Office européen des brevets

(11) EP 1 434 283 A2

(12) **EUROPEAN PATENT APPLICATION**

(43) Date of publication:
**30.06.2004 Bulletin 2004/27**

(51) Int Cl.[7]: **H01L 51/20**

(21) Application number: **03029942.4**

(22) Date of filing: **29.12.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **26.12.2002 JP 2002377141**

(71) Applicant: **NITTO DENKO CORPORATION**
**Osaka (JP)**

(72) Inventors:
- **The inventors have agreed to waive their entitlement to designation.**

(74) Representative: **Grünecker, Kinkeldey, Stockmair & Schwanhäusser Anwaltssozietät**
**Maximilianstrasse 58**
**80538 München (DE)**

(54) **Planar light source and display device using the same**

(57) A planar light source (10) has a solid light-emitting element (1) which emits light by electric energy and an anisotropic scattering color conversion layer (2) formed on the light-emitting side of the solid light-emitting element (1) with substantially no air layer interposed therebetween. The anisotropic scattering color conversion layer (2) has a light-transmitting resin (21), a microregion (22) dispersedly distributed in the light-transmitting resin (21) having birefringence different from that of the light-transmitting resin and at least one light-emitting material (23) incorporated in the light-transmitting resin (21) and/or microregion (22) and the at least one light-transmitting material (23) absorbs light emitted by the solid light-emitting element as excitation light to emit fluorescence or phosphorescence.

FIG. 1

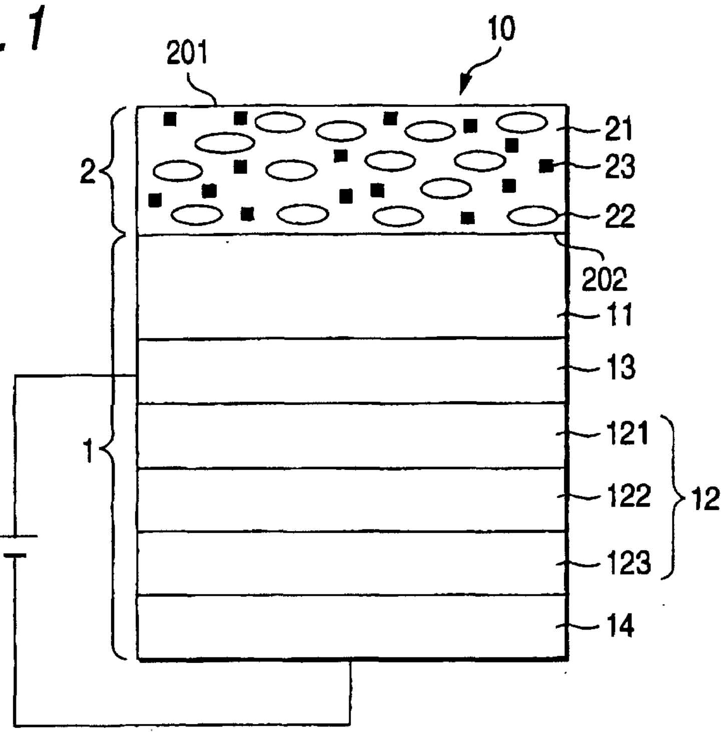


EP 1 434 283 A2

## Description

The present application is based on Japanese Patent Application No. 2002-377141, which is incorporated herein by reference.

## BACKGROUND OF THE INVENTION

### 1. Field of the Invention

The present invention relates to a planar light source and a display device comprising such a planar light source and more particularly to a planar light source which allows a light-emitting material contained in light-transmitting resin or the like with anisotropic scattering property to undergo luminescence with light emitted by a solid light-emitting element such as organic electroluminescence element (organic EL element) as excitation light, making it possible to emit natural light extracted from the solid light-emitting element as partially polarized light having other wavelength range rich with a predetermined linearly polarized light component and a high efficiency display device comprising such a planar light source.

### 2. Description of the Related Art

Electroluminescence elements (EL elements) or light-emitting diodes which emit light when a voltage is applied to a light-emitting layer disposed interposed between electrodes have been under extensive research and development as various light sources such as flat illuminator, light source for optical fiber, backlight for liquid crystal display and backlight for liquid crystal projector, not to mention display device. Among these light-emitting elements, the organic EL element is excellent in emission efficiency, drivability at low voltage and reduction of weight and cost and has recently been noted. The greatest concern with the use of such a solid light-emitting element as a light source is the enhancement of emission efficiency. For the purpose of obtaining an emission efficiency equal to that of fluorescent lamp, improvements in constitution, material, driving method and production method of element have been under extensive studies.

In a solid light-emitting element which allows a light-emitting layer itself to emit light such as EL element, however, the component of light thus emitted which has an incidence angle of not smaller than the critical angle determined by the difference between the refractive index of the light-emitting layer and the emitting medium (e.g., air layer) is totally reflected by the interface of the light-emitting layer with the emitting medium and kept in the light-emitting layer and thus cannot be occasionally extracted. It is known that supposing that the refractive index of the light-emitting layer is n, the extracting efficiency $\eta$ of the component of light generated in the light-emitting layer which is extracted from the light-emitting layer is approximated by the equation $\eta = 1/(2 \cdot n^2)$. For example, when the refractive index of the light-emitting layer is 1.7, $\eta$ is about 17%, demonstrating that about 80% or more of emission becomes guided light which goes toward the side of the element and then disappears as lost light.

In the case of organic EL element, the probability of production of singlet exciton contributing to the emission of light among excitons generated by the recombination of electron and hole injected from the electrodes is 1/4. Merely taking into account this probability, the emission efficiency of the entire element is as extremely low as not greater than 5%. However, as a means for enhancing the emission efficiency (quantum efficiency) of the light-emitting layer itself there has been recently developed, e.g., a light-emitting material which utilizes triplet exciton to cause phosphorescence. It has been found likely that such a light-emitting material exhibits a drastically raised quantum efficiency (see Patent Reference 1).

However, even when the emission efficiency (quantum efficiency) of the light-emitting layer itself is enhanced, the total emission efficiency obtained by multiplying the quantum efficiency by the ectracting efficiency is lowered if the extracting efficiency is low. In other words, there is yet room for drastic enhancement of emission efficiency that is attained by a synergistic effect developed if the extracting efficiency is enhanced.

Examples of proposed methods for enhancing the extracting efficiency include a method which comprises arranging such that the substrate constituting EL element is capable of condensing light itself to enhance the extracting efficiency (see Patent Reference 2), a method which comprises forming a light-emitting layer by a discotic liquid crystal to enhance the forward directionality of emitted light itself (see Patent Reference 3), a method which comprises forming a concave electrode constituting EL element (see Patent Reference 4), a method which comprises forming an inclined plane on the electrode constituting EL element (see Patent Reference 5), and a method which comprises forming a diffraction grating on the electrode constituting EL element (see Patent Reference 6). However, these proposals are disadvantageous in that the resulting EL element has a complicated constitution or the light-emitting layer itself has a deteriorated emission efficiency.

As a relatively simple method for enhancing the extracting efficiency there may be used a method which

comprises forming a light diffusion layer in an EL element to diffuse light and hence reduce the amount of light which satisfies the conditions for total reflection. As these methods there have been proposed various methods such as method which comprises using a diffusion plate having a particulate material having a refractive index distribution structure differing in refractive index from core to shell incorporated in dispersion in a transparent substrate (see Patent Reference 7), method which comprises using a diffusion member having a light diffusion layer having a single layer of light-transmitting particles provided on a light-transmitting substrate (see Patent Reference 8) and method which comprises dispersing scattered particles in the same material as the light-emitting layer of EL element (see Patent Reference 9). These proposals are characterized by the properties of scattered particles, the difference of refractive index from that of dispersed matrix, the dispersion state of particles, the forming site of light diffusion layer, etc.

In the case where a solid light-emitting element is used as backlight for liquid crystal display device, it is necessary that light emitted by the solid light-emitting element be converted to linearly polarized light through a polarizing plate so that it can be used for liquid crystal display because the emission is natural light having little polarization properties. Accordingly, the polarizing plate causes absorption loss of light, making it impossible to raise the percent utilization of light to greater than 50% to disadvantage.

As a method for eliminating these problems there has been proposed a method which comprises extracting emission from an organic EL element formed on an oriented layer as linearly polarized light (see Patent Reference 10). In accordance with such a method, the absorption loss in the polarizing plate of the liquid crystal display device can be reduced to half at maximum. However, it is likely that the interposition of the oriented layer can reduce the emission efficiency (quantum efficiency) of the organic EL element. Further, the emission from the organic EL element is totally reflected to become guided light going toward the side of the element which then disappears as lost light as in the related art.

On the other hand, a color conversion method has been proposed which comprises using as a filter a light-emitting material that absorbs emission from an organic EL element to emit fluorescence in the visible range (see Patent References 11 and 12). In accordance with this method, arbitrary visible light, including white light, can be extracted by adjusting the kind, added amount and mixing ratio of light-emitting material. Further, in the case where full-color display is effected in a display device, it is normally necessary that red, green and blue organic EL layers be formed for each pixel. However, even when the same organic EL layer is formed for each pixel, full-color display is made possible by using the aforementioned method to provide separately color filters coated with red, green and blue light-emitting materials, respectively. Since the production of the aforementioned color filter can be accomplished by a production technology developed in the art of color filter for liquid crystal display device as it is, the production cost can be reduced to advantage. However, since this system involves the emission of light in a solid material, the majority of emission is contained in the solid material as guided light as in the aforementioned other organic EL elements.

The guided light can be extracted from the light-emitting material to some extent by dispersing in the matrix having the light-emitting material dispersed therein particles having a refractive index different from that of the matrix or forming a light diffusion layer or lens sheet on the matrix. However, the use of an organic EL element provided with such a means as backlight for liquid crystal display device is disadvantageous in that the absorption loss by the polarizing plate cannot be reduced.

Further, a method has been proposed which comprises allowing light emitted by an organic EL element to be extracted through a polarized light scattering film (see Patent Reference 13). Such a proposed method is advantageous in that light which would be lost as guided light can be extracted by light scattering and light thus extracted is rich with linearly polarized light component, making it possible to reduce the absorption loss in the polarizing plate of the liquid crystal display device. However, there is neither disclosure nor suggestions as to the aforementioned color conversion method. Thus, this method is disadvantageous in that it is not suitable for full-color display.

As mentioned above, no planar light sources have been ever proposed which allow effective extraction of light which would be kept in a solid light-emitting element as guided light that will disappear as lost light, show little absorption loss in the polarizing plate when used as backlight for liquid crystal display device and allow extraction of arbitrary emission by color conversion.

[Patent Reference 1]
JP-2001-313178
[Patent Reference 2]
JP-63-314795
[Patent Reference 3]
JP-10-321371
[Patent Reference 4]
JP-11-214162
[Patent Reference 5]
JP-11-214163

[Patent Reference 6]
JP-11-283751
[Patent Reference 7]
JP-6-347617
[Patent Reference 8]
JP-2001-356207
[Patent Reference 9]
JP-6-151061
[Patent Reference 10]
JP-11-316376
[Patent Reference 11]
JP-3-152897
[Patent Reference 12]
JP-5-258860
[Patent Reference 13]
JP-2001-203074

## SUMMARY OF THE INVENTION

The invention has been worked out to solve these problems with the related art and an aim of the invention is to provide a high brightness planar light source which allows lost light contained in a solid light-emitting element to be extracted as guided light, can emit light composed of linearly polarized light in an arbitrarily controlled polarization direction (oscillation plane) and allows arbitrary emission to be extracted by color conversion and a display device having a high efficiency and a reduced consumption of electric power attained by the use of the planar light source.

From a first aspect, the present invention provides a planar light source comprising a solid light-emitting element which emits light by electric energy and an anisotropic scattering color conversion layer formed on the light-emitting side of the solid light-emitting element with substantially no air layer interposed therebetween, wherein the anisotropic scattering color conversion layer comprises a light-transmitting resin, a microregion dispersedly distributed in the light-transmitting resin having birefringence different from that of the light-transmitting resin and at least one light-emitting material incorporated in the light-transmitting resin and/or microregion and the light-transmitting material absorbs light emitted by the solid light-emitting element as excitation light to emit fluorescence or phosphorescence.

According to the invention, an anisotropic scattering color conversion layer is formed on the light-emitting side of a solid light-emitting element with substantially no air layer, which has a low refractive index (refractive index: 1), interposed therebetween. In this arrangement, light emitted by the solid light-emitting element enters in the anisotropic scattering color conversion layer without being reflected thereupon. The light which has entered in the anisotropic scattering color conversion layer acts as excitation light for the light-emitting material. The light-emitting material then absorbs the excitation light to emit fluorescence or phosphorescence. The color of fluorescence or phosphorescence can be arbitrarily selected by changing the kind of the light-emitting material.

The majority of light emitted by the anisotropic scattering color conversion layer thus excited is totally reflected by the interface of air depending on the difference in refractive index between the anisotropic scattering color conversion layer and air, and then transmitted by the anisotropic scattering color conversion layer. The linearly polarized component of the transmitted light having an oscillating plane parallel to the axial direction ($\Delta n1$ direction) of the microregion in which the difference in refractive index between the microregion and the light-transmitting resin shows maximum ($\Delta n1$) is selectively scattered strongly. The component of light thus scattered which is scattered at an angle smaller than the total reflection angle leaves the anisotropic scattering color conversion layer to the exterior (air).

Supposing that the light-transmitting resin has no microregion dispersedly distributed therein, no such selective polarization scattering occurs. Therefore, about 80% of light emitted by the light-emitting material excited in the anisotropic scattering color conversion layer is contained in the light-transmitting resin where it is repeatedly totally reflected due to solid angle.

In accordance with the invention, light contained in the light-transmitting resin leaves the anisotropic scattering color conversion layer only when it is scattered on the interface of the microregion with the light-transmitting resin to break the conditions of total reflection. Therefore, the emission efficiency can be arbitrarily controlled by the size or percent distribution of microregion.

On the other hand, the component of light scattered in $\Delta n1$ direction which is scattered at an angle greater than the total reflection angle, doesn't hit the microregion or has an oscillation plane in the direction other than $\Delta n1$ direction is contained in the anisotropic scattering color conversion layer by which it is transmitted while being repeatedly totally reflected. The polarized state of these components is eliminated by the birefringence of the anisotropic scattering color conversion layer. Thus, the conditions for $\Delta n1$ direction can be satisfied (linearly polarized light having an oscil-

lation plane parallel to $\Delta n1$ direction is generated). These components then are ready to leave the anisotropic scattering color conversion layer. As a result of the repetition of the aforementioned action, linearly polarized light having a predetermined oscillation plane is efficiently emitted by the anisotropic scattering color conversion layer. In other words, light which is inherently contained as guided light can be extracted as linearly polarized light.

As mentioned above, in accordance with the invention, the necessity of providing a special light-emitting unit comprising microlens, reflecting dot, etc. as in the related art can be eliminated, making it possible to efficiently release light emitted in the anisotropic scattering color conversion layer (light-emitting material) by the incident excitation light to the exterior as linearly polarized light. This leads to an advantage that the operating voltage or current of the solid light-emitting element can be reduced, making it possible to drastically prolong the life of the element. Further, the polarization direction (oscillation plane) of linearly polarized light can be arbitrarily predetermined according to the angle at which the anisotropic scattering color conversion layer is arranged (according to $\Delta n1$ direction). Moreover, the color of linearly polarized light emitted to the exterior can be arbitrarily predetermined by properly selecting the light-emitting material.

From a second aspect, the invention also provides a planar light source comprising a solid light-emitting element which emits light by electric energy, an anisotropic scattering layer formed on the light-emitting side of the solid light-emitting element with substantially no air layer interposed therebetween and a color conversion layer comprising at least one light-transmitting material formed interposed between the solid light-emitting element and the anisotropic scattering layer, wherein the anisotropic scattering layer comprises a light-transmitting resin and a microregion dispersedly distributed in the light-transmitting resin having birefringence different from that of the light-transmitting resin and the light-transmitting material absorbs light emitted by the solid light-emitting element as excitation light to emit fluorescence or phosphorescence.

The invention from the second aspect comprises an anisotropic scattering color conversion layer and a color conversion layer having a light-emitting material incorporated therein which are provided separately of each other. Since the two layers have substantially no air layer interposed therebetween, the effect similar to that of the invention from the first aspect.

Preferably, the microregion is formed by a glass-state material obtained by cooling and fixing a liquid crystal phase or a liquid-crystalline material, or a material obtained by crosslinking and fixing the liquid crystal phase of a polymerizable liquid crystal with energy radiation.

Alternatively, the microregion may be formed by a liquid crystal polymer having a glass transition temperature of not lower than 50°C and shows nematic liquid crystal phase at a temperature lower than the glass transition temperature of the light-transmitting resin.

More preferably, the difference in refractive index between the microregion and the light-transmitting resin has the following relationships:

$$0.03 \leq \Delta n1 \leq 0.5$$

$$0 \leq \Delta n2 \leq 0.03$$

$$0 \leq \Delta n3 \leq 0.03$$

supposing that the maximum difference in refractive index along the axis of the microregion is $\Delta n1$ and the differences in refractive index in the direction perpendicular to the axis along which the aforementioned maximum value is shown are $\Delta n2$ and $\Delta n3$.

Preferably, the solid light-emitting element of the invention is an organic electroluminescence element comprising at least one thin organic layer containing a light-transmitting layer formed between an anode and a cathode to advantage from the standpoint of reduction of driving voltage and consumed electric power.

The greatest disadvantage of organic electroluminescence element is that the element is deteriorated by a small amount of moisture or oxygen, causing the generation of dark spot with small defects as starting points, not to mention reduction of emission efficiency. For the details of dark spot, reference can be made to J. Mc Elvain et al., "J. Appl. Phys., Vol. 80, No. 10, page 6,002, 1996". In order to prevent these troubles, the element is normally sealed. Nevertheless, the complete prevention of the generation of dark spot cannot be easily accomplished. The dark spot drastically deteriorate the external appearance or viewability of the planar light source. In accordance with the invention, however, even when some dark spots are generated, light which is finally emitted 'to the observer is light emitted by the light-emitting material excited in the anisotropic scattering color conversion layer. Further, since this light is emitted to the exterior after being scattered many times in the anisotropic scattering color conversion layer, the deterioration

of viewability by the generation of dark spot can be little perceived.

Further, the invention provides a display device comprising a planar light source as aforementioned. Since the display device comprises a highly efficient planar light source, the electric power consumed by the display device can be drastically reduced.

## BRIEF DESCRIPTION OF THE DRAWINGS

In the accompanying drawings:

Fig. 1 is a longitudinal sectional view illustrating the schematic configuration of a planar light source according to an embodiment of implementation of the invention;

Fig. 2 is a longitudinal sectional view illustrating the schematic configuration of a planar light source according to another embodiment of implementation of the invention;

Fig. 3 is a longitudinal sectional view illustrating the schematic configuration of a planar light source according to a further embodiment of implementation of the invention;

Fig. 4 is a longitudinal sectional view illustrating the schematic configuration of a planar light source according to a still further embodiment of implementation of the invention;

Fig. 5 is a graph illustrating the emission spectrum of an organic EL element applied to a planar light source according to an embodiment of implementation of the invention; and

Fig. 6 is a graph illustrating the emission spectrum of a planar light source according to an embodiment of implementation of the invention.

## DETAILED DESCRIPTION OF THE PREFERRED EMBODIMENTS

An embodiment of implementation of the invention will be described in connection with the attached drawings.

Fig. 1 is a longitudinal sectional view illustrating the schematic configuration of a planar light source according to an embodiment of implementation of the invention. As shown in Fig. 1, a planar light source 10 according to the present embodiment comprises a solid light-emitting element 1 which emits light by electric energy and an anisotropic scattering color conversion layer 2 formed on the light-emitting side (upper side as viewed on Fig. 1) of the solid light-emitting element 1 with substantially no air layer interposed therebetween.

The solid light-emitting element 1 according to the present embodiment is defined to be an organic electroluminescence element (organic EL element) comprising a supporting substrate 11 made of glass plate, a thin organic layer 12 having a hole-transporting layer 121, a light-emitting layer 122 and an electron-transporting layer 123 laminated thereon, a transparent electrode (anode) 13 formed on the both sides of the thin organic layer 12 and a metal reflecting electrode (cathode) 14. When a voltage is applied across the electrodes 13 and 14, the anode 13 generates holes while the cathode 14 generates electrons. The holes and electrons migrate through the hole-transporting layer 121 and the electron-transporting layer 123, respectively, to the light-emitting layer 122 where they are then recombined to generate excitons that cause EL light emission. The component of light thus emitted which goes upward (upward as viewed on Fig. 1) is transmitted by the transparent electrode 13 and the glass substrate 11 from which it enters in the anisotropic scattering color conversion layer 2. On the other hand, the component of light thus emitted which goes downward (downward as viewed on Fig. 1) is reflected by the cathode 14, and then enters in the anisotropic scattering color conversion layer 2 in the same manner as mentioned above. During the aforementioned procedure, light emitted by the light-emitting layer 122 can enter in the anisotropic scattering color conversion layer 2 without being totally reflected because no air layer, which has a low refractive index (refractive index: 1), is interposed therebetween (However, part of light can be totally reflected depending on the refractive index of the transparent electrode 13 or the glass substrate 11). While the present invention has been described with reference to the case where as the solid light-emitting element 1 there is used an organic EL element from the standpoint of emission efficiency and reduction of driving voltage and consumed electric power, the invention is not limited thereto and any solid light-emitting element such as dispersed inorganic EL element and light-emitting diode can be used.

The organic material and electrode material to be used in the organic EL element 1, the layer configuration of the organic EL element 1 and the thickness of the various layers of the organic EL element 1 are not specifically limited. Any conventional organic EL elements may be used. The thin organic layer 12 may be formed by vacuum deposition of a low molecular material or spreading of a high molecular material. The method of forming the thin organic layer 12 is not specifically limited.

Referring to the layer configuration of the organic EL element 1, the organic EL element 1 may have an anode/light-emitting layer/cathode structure or anode/hole-transporting layer/electron-transporting light-emitting layer/cathode structure instead of anode 13/hole-transporting layer 121/light-emitting layer 122/electron-transporting layer 123/cathode 14 structure as in the present embodiment. Alternatively, a hole-injecting layer may be provided on the

interface of anode. An electron-injecting layer may be provided on the interface of cathode. In order to enhance the recombination efficiency, an electron block layer or hole block layer may be provided interposed between the layers. Essentially, high emission can be given at a small consumption of electric power by selecting a configuration, material and forming method that give a higher emission efficiency. In this arrangement, the light-emitting material 23 of the anisotropic scattering color conversion layer 2 described later can be efficiently excited to emit light to advantage.

As the material of the anode 13 and cathode 14 there may be used any proper material. In an ordinary organic EL element, as the anode 13 there may be used a transparent conductive layer made of indium tin oxide (ITO), tin oxide or the like. As the cathode 14 there is used a layer obtained by vacuum co-deposition of Mg and Ag at an atomic ratio of about 10 : 1, Ca electrode or Al electrode doped with a slight amount of Li from the standpoint of enhancement of electron injection efficiency by the reduction of work function of cathode, but the invention is not limited thereto.

As the supporting substrate 11 there may be used any ordinary method regardless of whether or no it is transparent. While the present embodiment has been described with reference to the case where as the supporting substrate 11 there is used a glass substrate and light emitted by the thin organic layer 12 is extracted on the supporting substrate 11 through the transparent electrode 13, as the supporting substrate 11a there may be used an opaque metal plate and the anisotropic scattering color conversion layer 2 is formed on the transparent electrode 13 as in the planar light source 10a shown in Fig. 2 (In this case, light is extracted on the side opposite the supporting substrate 11a). In addition to the arrangement that the anode 13 is a transparent electrode, the cathode 14 may be a transparent electrode obtained by forming a metal electrode having a thickness small enough to maintain a light transmission of from few nanometers to scores of nanometers from the interface of the thin organic layer 1, and then forming ITO on the metal electrode (In this case, light can be extracted on both sides of the thin organic layer 12). Further, an arrangement may be employed such that an anisotropic scattering color conversion layer 2 is formed interposed between a supporting substrate 11 made of glass substrate and a transparent electrode 13 as in the planar light source 10b shown in Fig. 3. In the configuration shown in Fig. 3, the glass substrate is present on the anisotropic scattering color conversion layer 2 (light-emitting side). However, the effect of the invention as described later can be exerted similarly in this configuration.

As the supporting substrate 11 there may be used also a polymer film. In some detail, the supporting substrate 11 may be formed by a polyethylene terephthalate, polyethylene naphthalate, polyether sulfone, polycarbonate, polyacrylate, polyether ketone, norbornene-based resin, triacetyl cellulose or the like. However, in the case where the supporting substrate 11 is formed closer to the emission side than the anisotropic scattering color conversion layer 2 as shown in Fig. 4, it is necessary that as the supporting substrate 11 there be selected one having no (or low) birefringence (optical anisotropy) to maintain the linear polarization obtained by the anisotropic scattering color conversion layer 2. If the supporting substrate 11 has birefringence, the linearly polarized light is converted to ellipsoidally polarized light depending on the relationship in optic axis and phase difference with the linearly polarized light emitted by the anisotropic scattering color conversion layer 2, increasing amount of the component absorbed by the polarizing plate when this arrangement is applied to liquid crystal display device, etc. Accordingly, it is necessary that as the supporting substrate 11 there be used a commercially available substrate having low or no optical anisotropy besides glass plate, epoxy resin substrate, cellulose triacetate film or norbornene-based resin film.

In the planar light sources shown in Figs. 1 to 3, the anisotropic scattering color conversion layer 2 is formed directly on the supporting substrate 11 or the transparent electrode 13 but may be formed on the supporting substrate 11 or the transparent electrode 13 with a transparent adhesive interposed therebetween. In this case, the refractive index of the adhesive is preferably adjusted taking into account the refractive index of the various layers to prevent the loss of light emitted by the organic EL element 1 due to total reflection as much as possible.

For example, in the case where the planar light source 10 shown in Fig. 1 comprises the anisotropic scattering color conversion layer 2 bonded to the glass substrate 11 with an adhesive, it is preferred that the refractive index of the adhesive be higher than that of the glass substrate 11 and lower than that of the light-transmitting resin 21 of the anisotropic scattering color conversion layer 2 described later. In this arrangement, no total reflection can occur on the glass substrate 11/adhesive interface and the adhesive/anisotropic scattering color conversion layer 2 interface, making it possible for light emitted to efficiently enter in the anisotropic scattering color conversion layer 2. However, even when the refractive index of the adhesive does not necessarily satisfy the aforementioned relationship, the difference in refractive index between the two components is about 0.1 or less, making it unlikely that the effect of the invention can be remarkably reduced.

However, care must be taken in bonding the anisotropic scattering color conversion layer 2 to the transparent electrode 13 with an adhesive as in the planar light source 10a shown in Fig. 2 or the planar light source 10b shown in Fig. 3. For example, the refractive index of ITO which is dedicated to transparent electrode is as great as about 1.8 to 2.0. The refractive index of an acrylic adhesive is from about 1.45 to 1.5. Thus, the difference in refractive index between the two materials is relatively great. Therefore, the effect of total reflection cannot be neglected. Accordingly, it is necessary that the refractive index of the adhesive be raised as much as possible, though difficultly to the level of the refractive index of ITO, to reduce the loss due to total reflection.

The anisotropic scattering color conversion layer 2 comprises a light-transmitting resin 21, a microregion 22 dispersedly distributed in the light-transmitting resin 21 having birefringence different from that of the light-transmitting resin and at least one light-emitting material 23 incorporated in the light-transmitting resin 21 and/or microregion 22 (the light-emitting material 23 is shown incorporated in the light-transmitting resin 21 in Fig. 1).

The shape of the anisotropic scattering color conversion layer 2 is not specifically limited so far as it has at least two opposing flat planes. As shown in Fig. 1, however, the anisotropic scattering color conversion layer 2 is preferably in the form of film, sheet or plate having a rectangular section from the standpoint of total reflection efficiency, particularly in the form of film from the standpoint of handleability. The thickness of the anisotropic scattering color conversion layer 2 is preferably not greater than 10 mm, more preferably from 0.1 to 5 mm, more preferably from 0.4 mm to 2 mm.

The two opposing planes 201 and 202 of the anisotropic scattering color conversion layer 2 preferably have a mirror-smoothness from the standpoint of the efficiency in containment of light emitted by the light-emitting material 23 by total reflection. However, when the two opposing planes 201 and 202 of the anisotropic scattering color conversion layer 2 are lack of smoothness, a film or sheet having an excellent light transmission may be separately bonded to the light-transmitting resin 21 with a transparent adhesive so that the smooth surface of the light-transmitting film or sheet thus bonded can be a totally reflective interface to exert the same effect.

The light-emitting material 23 is preferably uniformly dissolved or dispersed in either or both of the light-transmitting resin 21 and the microregion 22. It is not desired that light is scattered by the light-emitting material 23. Therefore, the light-emitting material 23 is more preferably a soluble material. In the case where the light-emitting material 23 is dispersed in the light-transmitting resin 21 or the microregion 22, the size of dispersed light-emitting material is preferably as small as possible from the standpoint of inhibition of unnecessary scattering of light. The light-emitting material 23 may be dissolved or dispersed in the light-transmitting resin 21 or the microregion 22 by a proper method such as method involving the incorporation of the light-emitting material 23 in the material constituting the light-transmitting resin 21 or microregion 22 optionally with other additives during the formation of the anisotropic scattering color conversion layer 2.

As the light-emitting material 23 there may be used one or more proper materials which absorb and are excited by ultraviolet rays or visible rays to emit light in the visible range. The light-emitting material 23 is not specifically limited. In some detail, a fluorescent material or phosphorescent material made of an organic dye or inorganic pigment which emits fluorescence, which is light emitted from excited singlet, or phosphorescence, which is light emitted from triplet, may be used.

As the light-emitting materials 23 there are preferably used materials having an emission wavelength of blue, green and red regions singly or in admixture. For example, the arrangement that the light-emitting material 23 is made of an organic fluorescent dye (blue fluorescent material, green fluorescent material, red fluorescent material) will be described in detail below.

The organic compound to be used as blue fluorescent material is not specifically limited so far as it shows a fluorescent peak wavelength of from not lower than 380 nm to lower than 480 nm in the form of solution. In some detail, at least one of stilbene derivative, distyryl arylene derivative and trisstyryl arylene derivative as disclosed in JP-A-6-203963 is preferably included. Other preferred examples of the blue fluorescent material include polycyclic aromatic compounds such as anthracene, perylene and coronene, and alkyl-substitution products thereof.

The organic compound to be used as green material is not specifically limited so far as it shows a fluorescent peak wavelength of from not lower than 480 nm to lower than 580 nm in the form of solution. Specific examples of the green fluorescent material employable herein include coumarine compounds such as 3-(2'-benzimidazolyl)-7-N,N-diethylaminocoumarine (coumarine 535), 3-(2-benzothiazolyl)-7- diethylaminocoumarine (coumarine6), 2,3,5,6-iH,4H-tetrahydro-8-trifluoromethylquinolidino-<9 ,9a,1-gh> coumarine (coumarine 540A), 3-(5-chloro-2-benzothiazolyl)- 7-diethylaminocoumarine (coumarine 34), 4-trifluoromethyl- piperidino[3,2-g]coumarine (coumarine 340), N-ethyl-4-trifluoromethyl-piperidino[2,3-h] coumarine and 9-cyano-1,2, 4,5-3H,6H,10H-tetrahydro-1-benzopyrano[9,9a1-gh]quinolidine-10-one (coumarine 337), xanthine dyes such as 2,7-dichlorofluorescene, tetracene, and quinacridone compounds.

The organic compound to be used as red material is not specifically limited so far as it shows a fluorescent peak wavelength of from not lower than 580 nm to lower than 650 nm in the form of solution. Specific examples of the red fluorescent material employable herein include dicyanomethylene pyrane derivatives, dicyanomethylene thipyrane derivatives, fluorescein derivatives and perylene derivatives which are disclosed to be used as red oscillation laser dye in European Patent Disclosure No. 0281381.

It is necessary that these organic compounds be incorporated in an amount of from 0.1 to 10 mol-%, preferably from 0. 5 to 5 mol-% based on the amount of the organic compound constituting the layer (light-transmitting resin 21 or microregion 22) to prevent concentration quenching. Taking into account the process for the preparation of the anisotropic scattering color conversion layer 2 or the reduction of emission efficiency in the working atmosphere, a material having an excellent fastness is preferably used as the light-emitting material 23.

The anisotropic scattering color conversion layer 2 can be formed by a proper method such as method which comprises subjecting one or more proper materials having an excellent transparency such as polymer and liquid crystal to a proper orientation such as stretching in a combination such that regions having different birefringence are formed to obtain an oriented film. As previously mentioned, it is preferred that the light-emitting material 23 be dispersed in a small size. Therefore, it is preferred that at least one of the materials to be combined be miscible with the light-emitting material 23 in which it is dispersed with a good compatibility.

Examples of the aforementioned combination of materials include combination of polymer and liquid crystal, combination of isotropic polymer and anisotropic polymer, and combination of anisotropic polymers. From the standpoint of dispersibility and distribution of microregions 22, the combination is preferably such that phase separation occurs. Such a combination makes it possible to control dispersibility and distribution of microregions 22 by the compatibility of the materials to be combined. A proper method such as method which comprises solubilizing non-compatible materials with a solvent and method which comprises mixing non-compatible materials while being melted under heating may be used to effect phase separation.

In the case where the aforementioned combination of materials such as combination of polymer and liquid crystal and combination of isotropic polymer and anisotropic polymer is subjected to orientation by stretching, the conditions of orientation of the combination of anisotropic polymers may be properly controlled by arbitrarily adjusting the stretching temperature or stretching ratio to form the desired anisotropic scattering color conversion layer 2. Anisotropic polymers are classified as positive or negative according to the change of refractive index in the stretching direction. In the present embodiment, both positive and negative anisotropic polymers may be used. Any of combination of positive anisotropic polymers, combination of negative anisotropic polymers and combination of positive and negative anisotropic polymers may be used.

Examples of the aforementioned polymers include ester-based polymers such as polyethylene terephthalate and polyethylene naphthalate, styrene-based polymers such as polystyrene and acrylonitrile-styrene copolymer (AS polymer), olefin-based polymers such as polyethylene, polypropylene, polyolefin having cyclo or norbornene structure and ethylene-propylene copolymer, acrylic polymers such as polymethyl methacrylate, cellulose-based polymers such as cellulose diacetate and cellulose triacetate, amide-based polymers such as nylon (aliphatic polyamide) and aromatic polyamide.

Examples of the aforementioned transparent polymers include carbonate-based polymers, vinyl chloride-based polymers, imide-based polymers, sulfone-based polymers, polyether sulfones, polyether ether ketones, polyphenylene sulfides, vinyl alcohol-based polymers, vinylidene chloride-based polymers, vinyl butyral-based polymers, arylate-based polymers, polyoxymethylenes, silicone-based polymers, urethane-based polymers, ether-based polymers, vinyl acetate-based polymers, mixture thereof, and phenolic, melamine-based, acrylic, urethane-based, urethane acryl-based, epoxy-based and silicone-based thermosetting or ultraviolet-curing polymers.

On the other hand, examples of the aforementioned liquid crystal include low molecular liquid crystals or crosslinkable liquid crystal monomers which show nematic phase or smectic phase at room temperature or high temperature such as cyanobiphenyl-based liquid crystal, cyanophenylcyclohexane-based liquid crystal, cyanophenylester-based liquid crystal, benzoic acid phenylester-based liquid crystal, phenylpyrimidine-based liquid crystal and mixture thereof, and liquid crystal polymers which show nematic phase or smectic phase at room temperature or high temperature. The aforementioned crosslinkable liquid crystal monomers are normally subjected to orientation followed by a proper crosslinking by heat or light to produce a polymer.

In order to obtain an anisotropic scattering color conversion layer 2 having an excellent heat resistance and durability, a combination of a polymer having a glass transition temperature of preferably not lower than 50°C, more preferably not lower than 80°C, particularly not lower than 120°C, and a crosslinkable liquid crystal monomer or liquid crystal polymer is preferably used. As the aforementioned liquid crystal polymer there may be used a proper main-chain or side-chain type liquid crystal polymer. The kind of the liquid crystal polymer is not specifically limited. From the standpoint of formability, thermal stability, film-forming properties and orientability of microregion 22 having an excellent uniformity in distribution of particle diameters, a liquid crystal polymer having a polymerization degree of preferably not smaller than 8, more preferably not smaller than 10, particularly from 15 to 5,000 is preferably used.

The anisotropic scattering color conversion layer 2 comprising a liquid crystal polymer can be formed by mixing one or more polymers with one or more liquid crystal polymers for forming the microregion 22 to form a polymer film having a liquid crystal polymer incorporated in dispersion therein in such an arrangement that the liquid crystal polymer occupies the microregion, and then subjecting the polymer film to a proper orientation to form regions having different birefringence.

Referring to the difference in refractive index between the microregion 22 and the light-transmitting resin 21, the maximum difference in refractive index along the axis of the microregion is supposed to be $\Delta n1$ and the differences in refractive index in the direction perpendicular to the axis along which the aforementioned maximum value is shown are supposed to be $\Delta n2$ and $\Delta n3$. From the standpoint of controllability of refractive index differences $\Delta n1$, $\Delta n2$ and $\Delta n3$ by the aforementioned orientation, as the aforementioned liquid crystal polymer there is preferably used a liquid

crystal polymer having a glass transition temperature of not lower than 50°C which shows nematic liquid crystal phase at a temperature range lower than the glass transition temperature of the polymer (light-transmitting resin 21) to be combined therewith. Specific examples of such a liquid crystal polymer include side-chain type liquid crystal polymers having monomer units represented by the following general formula:

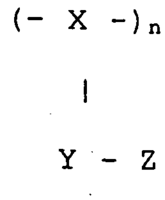

In the aforementioned general formula, X represents a skeleton group forming the main chain of the liquid crystal polymer which may be formed by proper connecting chains such as linear, branched and cyclic connecting chains. Specific examples of the skeleton group include polyacrylates, polymetharylates, poly-α-haloacrylates, poly-α-cyanoacrylates, polyacrylamides, polyacrylonitriles, polyphthacrylonitriles, polyamides, polyesters, polyurethanes, polyethers, polyimides, and polycyloxanes.

Y represents a spacer group branched from the main chain. From the standpoint of formability of anisotropic scattering color conversion layer 2 such as controllability of refractive index difference, the spacer group Y is preferably ethylene, propylene, butylene, pentylene, hexylene, octylene, decylene, undecylene, dodecylene, octadecylene, ethoxyethylene or methoxybutylene. On the other hand, Z represents a mesogen group which provides liquid crystal-orientability.

The aforementioned nematic orientation side-chain type liquid crystal polymer may be a proper thermoplastic polymer such as homopolymer and copolymer having monomer units represented by the aforementioned general formula, particularly having an excellent monodomain orientation.

The anisotropic scattering color conversion layer 2 comprising a nematic orientation liquid crystal polymer may be formed by mixing a polymer for forming a polymer film with a liquid crystal polymer having a glass transition temperature of preferably not lower than 50°C, more preferably not lower than 60°C, particularly not lower than 70°C which shows nematic liquid crystal phase at a temperature range lower than the glass transition temperature of the polymer to form a polymer film having a liquid crystal polymer incorporated in dispersion therein in such an arrangement that the liquid crystal polymer occupies the microregion, and then subjecting the liquid crystal polymer forming the microregion 22 to heat treatment so that it is oriented to nematic liquid crystal phase which is then fixed by cooling.

The polymer film having unoriented microregions 22 incorporated in dispersion therein (light-transmitting resin 21), i.e., film to be oriented may be formed also by developing the materials in the form of monomer, and then subjecting the materials to polymerization by heat treatment or irradiation with ultraviolet rays to form a film besides a proper method such as casting method, extrusion method, injection method, roll forming method and flow casting method.

In order to obtain an anisotropic scattering color conversion layer 2 having microregions 22 distributed therein in an excellent uniformity, a method is preferably employed which comprises subjecting a mixture of forming materials with a solvent to film formation by casting method, flow casting method or the like. In this case, the size and distribution of the microregion 22 can be controlled by the kind of the solvent used, the viscosity of the mixture, the drying rate of the spread of the mixture, etc. The reduction of the area of the microregion 22 can be effectively accomplished by the reduction of the viscosity of the mixture or the enhancement of the drying rate of the spread of the mixture.

The thickness of the film to be oriented may be properly predetermined but is preferably from 1 μm to 3 mm, more preferably from 5 μm to 1 mm, particularly from 10 to 500 μm from the standpoint of orientability. During the film formation, proper additives such as dispersant, surface active agent, toner, fire retardant, release agent and oxidation inhibitor may be added.

The orientation of the film can be accomplished by one or more of proper methods which can control refractive index by orientation such asmonoaxial, biaxial, successive biaxial or z-axis stretching method, rolling method, method which comprises applying an electric field or magnetic field to the film at a temperature higher than its glass transition temperature or liquid crystal transition temperature, and then rapidly cooling the film to fix orientation, method which comprises subjecting the film to flow orientation during film forming and method which comprises subjecting a liquid crystal to self orientation on the basis of slight orientation of isotropic polymer. Accordingly, the anisotropic scattering color conversion layer 2 thus obtained may be in the form of oriented film or unoriented film. In order to obtain an oriented film, a brittle polymer may be used, but a polymer having an excellent elongation is preferably used.

In the case where the microregion 22 is formed by a liquid crystal polymer, the polymer film may be oriented by heating and melting the polymer film at a temperature at which the liquid crystal polymer dispersedly distributed in the polymer film shows a desired liquid crystal phase such as nematic liquid crystal phase, orienting the material thus

melted under the action of orientation controlling force, and then rapidly cooling the material to fix orientation. The orientation of the microregion 2 is preferably in monodomain state from the standpoint of prevention of scattering of optical properties.

Examples of the aforementioned orientation controlling force employable herein include proper controlling forces capable of orienting liquid crystal such as stretching force for stretching the polymer film by a proper factor, shearing force during film forming, magnetic field and electric field. One or more of these controlling forces may be acted to orient the liquid crystal polymer.

The portion other than the microregion 22 in the anisotropic scattering color conversion layer 2, i.e., light-transmitting resin 21 may be birefringent or isotropic. The anisotropic scattering color conversion layer 2 which is entirely birefringent can be obtained by subjecting an orientation-birefringent polymer for forming a film to molecular orientation during film forming as mentioned above. If necessary, birefringence can be provided or controlled by subjecting the film to a known orientation such as stretching. Further, the anisotropic scattering color conversion layer 2 which is isotropic in a proportion other than microregion 22 can be obtained by subjecting an isotropic polymer for forming a film to stretching at a temperature range of not higher than the glass transition temperature of the polymer.

As previously mentioned, the light-transmitting resin 21 and the microregion 22 have different birefringence. In some detail, as previously mentioned, referring to the difference in refractive index between the microregion 22 and the light-transmitting resin 21, supposing that the maximum difference in refractive index along the axis of the microregion ($\Delta n1$ direction) is $\Delta n1$ and the differences in refractive index in the direction perpendicular to the axis along which the aforementioned maximum value ($\Delta n2$ direction and $\Delta n3$ direction) is shown are $\Delta n2$ and $\Delta n3$, $\Delta n1$ is preferably great to a proper extent and $\Delta n2$ and $\Delta n3$ are preferably as small as possible, even zero, from the standpoint of total reflection as described later. The anisotropic scattering color conversion layer 2 according to the present embodiment is controlled such that the following relationships can be established:

$$0.03 \leq \Delta n1 \leq 0.5$$

$$0 \leq \Delta n2 \leq 0.03$$

$$0 \leq \Delta n3 \leq 0.03$$

More preferably, $\Delta n2$ is equal to $\Delta n3$. These refractive index differences can be controlled by the refractive index of the materials used or the orientation method.

By establishing these refractive index differences $\Delta n1$, $\Delta n2$ and $\Delta n3$, the $\Delta n1$ direction linearly polarized component of light emitted by excitation light which has entered in the anisotropic scattering color conversion layer 2 is strongly scattered at an angle smaller than critical angle (total reflection angle), making it possible to increase the amount of light which leaves the anisotropic scattering color conversion layer 2 to the exterior. On the other hand, other linearly polarized components can be difficultly scattered and thus are repeatedly totally reflected, making it possible for themselves to be contained in the anisotropic scattering color conversion layer 2.

The difference between the refractive index of the microregion 22 in various axes and the refractive index of the light-transmitting resin 21 ($\Delta n1$, $\Delta n2$ and $\Delta n3$) means the difference between the refractive index of the microregion 22 in various axes and the average refractive index of the light-transmitting resin 21 if the light-transmitting resin 21 is optically isotropic or the difference in refractive index in the axial direction between the microregion 22 and the light-transmitting resin 21 because the light-transmitting resin 21 and the microregion 22 are normally coincident with each other in main axial direction if the light-transmitting resin 21 is optically anisotropic.

$\Delta n1$ direction is parallel to the oscillating plane of linearly polarized light emitted by the anisotropic scattering color conversion layer 2 and thus is preferably parallel to two opposing planes 201, 202 of the anisotropic scattering color conversion layer 2. $\Delta n1$ direction may be properly predetermined according to liquid crystal cell to which the planar light source 10 can be applied so far as it is parallel to two opposing planes 201, 202.

The microregion 22 is preferably dispersedly distributed as uniformly as possible in the anisotropic scattering color conversion layer 2 from the standpoint of homogeneity of effect of scattering in the microregion 22. The size of the microregion 22, particularly the length of the microregion 22 in $\Delta n1$ direction, which is a scattering direction, has an effect on back scattering (reflection) or wavelength dependence. The size of the microregion 22, particularly the length of the microregion 22 in $\Delta n1$ direction, is preferably from 0.05 to 500 μm, more preferably from 0.1 to 250 μm, particularly from 1 to 100 μm from the standpoint of enhancement of percent utilization of light, prevention of coloring by wavelength dependence, inhibition of visibility by visualization of microregion 22 and inhibition of clear display, film-forming properties and film strength. Although the microregion 22 is normally present in domain state in the anisotropic

scattering color conversion layer 2, the length of the microregion 22 in Δn2 direction is not specifically limited.

The proportion of the microregion 22 in the anisotropic scattering color conversion layer 2 may be properly predetermined taking into account the standpoint of scattering properties in Δn1 direction but is preferably from 0.1 to 70% by weight, more preferably from 0.5 to 50% by weight, particularly from 1 to 30% by weight taking into account film strength as well.

The anisotropic scattering color conversion layer 2 according to the present embodiment may be in the form of single layer or laminate of two or more layers. By laminating the anisotropic scattering color conversion layers 2, a synergistic effect of scattering can be exerted in addition to the effect exerted by adding to the thickness of the anisotropic scattering color conversion layer 2. Such a laminate is preferably arranged such that Δn1 direction of the various layers are parallel to each other for the purpose of developing the scattering effect. The number of layers to be laminated is a proper number of 2 or more.

The anisotropic scattering color conversion layers 2 to be laminated may be the same or different in Δn1, Δn2 and Δn3. Further, the light-emitting material 23 to be incorporated in the various anisotropic scattering color conversion layers 2 may be the same or different. Although the various layers are preferably parallel to each other in Δn1 direction, etc. as previously mentioned, some deviation due to error in working is tolerated. In the case where Δn1 direction, etc. vary from anisotropic scattering color conversion layer 2 to anisotropic scattering color conversion layer 2, these anisotropic scattering color conversion layers are preferably laminated in such an arrangement that their averaged directions are parallel to each other.

The anisotropic scattering color conversion layer 2 is preferably arranged such that it differs in phase throughout the whole or part thereof because it is necessary that polarization be properly eliminated during the transmission of light by the anisotropic scattering color conversion layer 2. It is essential that the retardation axis (axis in Δn1 direction) of the anisotropic scattering color conversion layer 2 and the polarization axis (oscillating plane) of the linearly polarized light which can be difficultly scattered cross each other. It is therefore thought that polarization due to phase difference can difficultly occur, but slight scattering causes the change of apparent angle, resulting in polarization.

Since such polarization can occur, it is normally preferred that the anisotropic scattering color conversion layer 2 have an in-plane phase difference of not smaller than 5 nm. However, the in-plane phase difference varies with the thickness of the anisotropic scattering color conversion layer 2. Such a phase difference can be given to the anisotropic scattering color conversion layer 2 by a proper method such as method which comprises incorporating a particulate birefringent material in the anisotropic scattering color conversion layer 2 or attaching the particulate birefringent material to the surface of the anisotropic scattering color conversion layer 2, method which comprises rendering the light-transmitting resin 21 birefringent, method involving these methods in combination and method which comprises integrally laminating birefringent films.

In the planar light source 10 according to the present embodiment, a polarization-maintaining lens sheet or light diffusion layer may be provided on the emission side (upper side) of the anisotropic scattering color conversion layer 2. In addition, a wavelength cut filter or phase difference film may be provided on the anisotropic scattering color conversion layer 2 as necessary.

The lens sheet is provided for the purpose of controlling the path of light (linearly polarized light) emitted by the planar light source 10 while maintaining its polarization degree to enhance the directionality toward the front, which is favorable for visual recognition, so that the scattering emission has an intensity peak when it goes forward.

The wavelength cut filter is provided for the purpose of preventing light directly from the organic EL element 1 from entering in the liquid crystal display element illuminated by the planar light source 10 according to the present embodiment. In the case where excitation light is ultraviolet ray, the wavelength cut filter is preferably used because it is necessary to prevent the deterioration of the liquid crystal or polarizing plate by ultraviolet ray. The wavelength cut filter may be used also for the purpose of excluding visible light having an unnecessary wavelength range. Instead of separately providing the wavelength cut filter, the anisotropic scattering color conversion layer 2 or other optical members may have an ultraviolet absorber or the like incorporated therein to have a wavelength cutting capacity.

As mentioned above, the planar light source 10 according to the present embodiment uses light emitted by the organic EL element 1 to emit linearly polarized light from the anisotropic scattering color conversion layer 2. At the same time, the planar light source 10 can control the polarization direction (oscillating plane). Further, by properly selecting the light-emitting material 23, the color of linearly polarized light can be arbitrarily predetermined (white emission can be also obtained by adding a plurality of light-emitting materials 23 in a properly adjusted amount). Therefore, the planar light source 10 according to the present embodiment can be used for various devices or purposes utilizing linearly polarized light such as liquid crystal display device.

The planar light source according to the present embodiment may comprise a solid light-emitting element 1, an anisotropic scattering layer 2a formed on the light-emitting side (upper side as viewed on Fig. 4) of the solid light-emitting element 1 with substantially no air layer interposed therebetween and a color conversion layer 2b comprising at least one light-transmitting material formed interposed between the thin organic layer 12 (particularly light-emitting layer) of the solid light-emitting element 1 and the anisotropic scattering layer 2a as shown in Fig. 4. In other words,

the anisotropic scattering layer 2a and the light-emitting material (color conversion layer 2b) may be provided separately of each other.

The anisotropic scattering layer 2a may be prepared in the same manner as the aforementioned anisotropic scattering color conversion layer 2 except that the light-emitting material 23 is not dispersed therein. The color conversion layer 2b may be formed by dispersing the aforementioned light-emitting material 23 in a transparent resin or by incorporating the light-emitting material 23 in the substrate 11 itself (that is, the substrate 11 acts as a color conversion layer 2b as well itself). In this arrangement, no air layer is provided interposed between the light-emitting layer of the thin organic layer 12 and the color conversion layer 2b and between the color conversion layer 2b and the anisotropic scattering layer 2a. Accordingly, the planar light source 10c shown in Fig. 4, too, allows excitation light emitted in the color conversion layer 2b to enter in the anisotropic scattering layer 2a without being totally reflected, making it possible to exert the same effect as the planar light source 10 shown in Fig. 1. Instead of the anisotropic scattering layer 2a, the aforementioned anisotropic scattering color conversion layer 2 may be used in combination with the color conversion layer 2b.

Example

The characteristics of the invention will be further disclosed in the following examples and comparative examples.

<Example 1>

(1) Preparation of organic EL element

A glass substrate was subjected to DC sputtering on one side thereof using an ITO ceramic target (In2O3 : SnO2 = 90% by weight : 10% by weight) to form a transparent electrode (anode) made of ITO layer to a thickness of 100 nm. Thereafter, the ITO layer was etched with a photoresist to form a pattern having a luminous area of 15 mm x 15 mm. Subsequently, the ITO layer was subjected to ultrasonic cleaning and then to ozone cleaning using a low voltage UV lamp. Subsequently, thin organic layers were sequentially vacuum-deposited on the ITO layer under the following conditions.

In some detail, CuPc (chemical formula 1) was vacuum-deposited on the ITO layer as a hole-injecting layer at a rate of 0.3 nm/s to a thickness of 15 nm.

[Chemical formula 1]

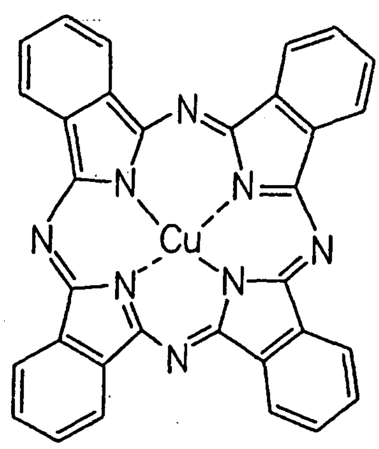

α-NPD (chemical formula 2) was then vacuum-deposited on the CuPc layer as a hole-transporting layer at a rate of 0.3 nm to a thickness of 50 nm.

[Chemical formula 2]

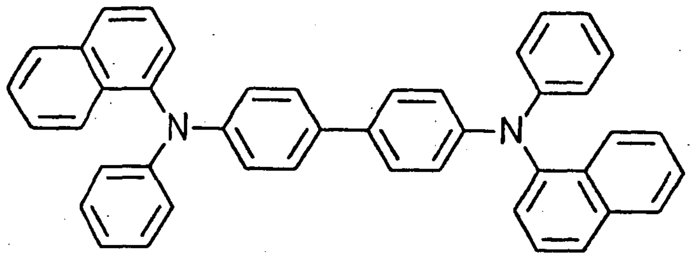

PBD (chemical formula 3) was then vacuum-deposited on the α-NPD layer as an electron-transporting light-emitting layer at a rate of 0.3 nm/s to a thickness of 50 nm.

[Chemical formula 3]

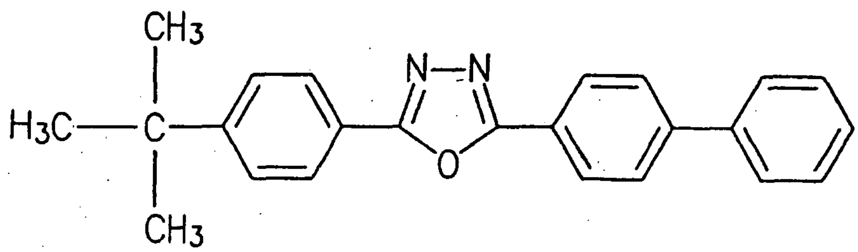

Thereafter, Mg and Ag were together vacuum-deposited on the PBD layer at a rate of 1 nm/s and 0.1 nm/s, respectively, to form a MgAg layer to a thickness of 100 nm. Thereafter, an Ag layer was formed on the MgAg layer as a cathode to a thickness of 50 nm from the standpoint of prevention of oxidation of the MgAg layer. Subsequently, the glass substrate was withdrawn from the vacuum metallizer. An ultraviolet-curing epoxy resin was then dropped onto the cathode. A slide glass was then put on the cathode. When the epoxy resin was thoroughly spread over the cathode, the epoxy resin was then irradiated with light from a high voltage UV lamp so that it was cured to seal the element.

10 V dc voltage was then applied to the organic EL element thus prepared. As a result, a current of 31.2 mA (current density: 9.63 mA/cm$^2$) passed through the organic EL element to cause the emission of blue electroluminescence. The blue electroluminescence was then measured for front brightness using a Type BM9 brightness meter (produced by TOPCON CORPORATION). The result was 46 cd/m$^2$. Fig. 5 shows the measurements of emission spectrum of the organic EL element thus prepared by a type MCPD3000 high-sensitivity multifunctional multichannel spectrophotometer (produced by Otsuka Electronics Co., Ltd.). The organic EL element thus prepared showed a tendency to lower its brightness with time after the application of voltage. Accordingly, in Example 1 and the following examples and comparative examples, the measurement of brightness was made 2 seconds after the application of voltage.

(2) Preparation of anisotropic scattering color conversion layer

A 20 wt-% dichloromethane solution of 950 parts (hereinafter parts by weight) of a norbornene-based resin (trade name: Arton, produced by JSR Corporation; glass transition temperature: 182°C), 50 parts of a liquid crystal polymer represented by the following chemical formula (4) (glass transition temperature: 80°C; nematic liquid crystallization temperature: 100°C to 290°C) and 2 parts of 3-(2-benzothiazolyl)-7-diethylaminocoumarine (coumarine 6) represented by the following chemical formula (5) was casted to form a film to a thickness of 100 µm. The film was stretched by a factor of 3 at 180°C, and then rapidly cooled to form an anisotropic scattering color conversion layer in the form of film.

[Chemical formula 4]

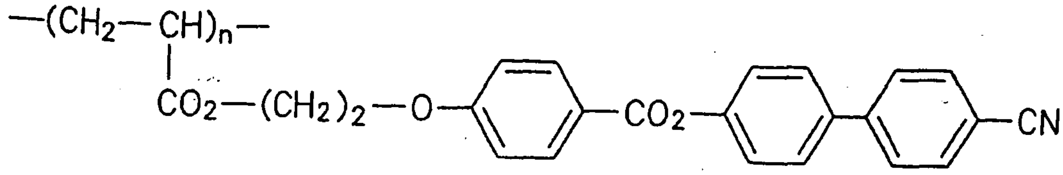

[Chemical formula 5]

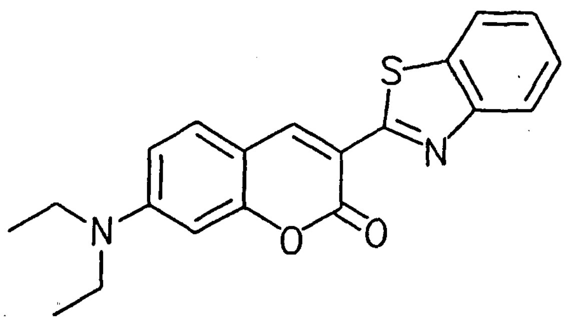

The anisotropic scattering color conversion layer had a liquid crystal polymer dispersed in a transparent film made of a norbornene-based resin in the form of domains having substantially the same shape arranged longitudinally in the stretching direction and showed Δn1 of 0.23 and Δn2 and Δn3 of 0.029 as refractive index difference. For the measurement of refractive index difference, a sample obtained by stretching a norbornene-based resin alone under the same conditions as mentioned above and a sample obtained by spreading the aforementioned liquid crystal polymer alone over an oriented layer and then fixing the orientation were each measured for refractive index using an Abbe refractometer. The difference of refractive index was then calculated as Δn1, Δn2 and Δn3. Coumarine 6 was observed dissolved in the norbornene-based resin. Further, the average diameter of the microregions (domain of liquid crystal polymer) was measured by color developed on the basis of phase difference by observation under polarization microscope. As a result, the length of the microregion in Δn1 was found to be about 5 μm.

(3) Formation of anisotropic scattering color conversion layer on organic EL element

The anisotropic scattering color conversion layer (film) thus obtained in the step (2) was then stuck to the glass substrate of the organic EL element thus prepared in the step (1) with an acrylic transparent adhesive layer (thickness: 25 μm). Under these conditions, a voltage of 10 V was then applied to the organic EL element. As a result, current passed through the organic EL element on substantially the same order as mentioned in the step (1) to cause the emission of green electroluminescence from coumarine 6 as shown in Fig. 6. The brightness of the green electroluminescence was 146 cd/$m^2$.

(4) Provision of polarizing plate

A type NPF-SEG1425DU polarizing plate (produced by NITTO DENKO CORPORATION) was then provided on the anisotropic scattering color conversion layer for planar light source prepared in the step (3) in such an arrangement that the stretching direction of the anisotropic scattering color conversion layer and the transmission axis of the polarizing plate are parallel to each other. A voltage of 10 V was then applied to the organic EL element. As a result, the brightness of the electroluminescence thus emitted was 91 cd/$m^2$. A sample obtained by providing the polarizing plate on the anisotropic scattering color conversion film in such an arrangement that the stretching direction of the

anisotropic scattering color conversion layer and the transmission axis of the polarizing plate are perpendicular to each other was then subjected to the same measurement as mentioned above. As a result, the brightness of the electroluminescence thus emitted was 47 cd/$m^2$. It was thus made obvious that the planar light source according to the invention emits polarized light rich with a linearly polarized light component the electric field of which oscillates in the stretching direction of the anisotropic scattering color conversion film.

<Comparative Example 1>

The procedure of the step (2) of preparing an anisotropic scattering color conversion layer of Example 1 was followed except that the film having a thickness of 100 μm formed by casting was not subjected to stretching before the formation of the color conversion layer in the form of film. The color conversion layer thus prepared was then stuck to the glass substrate of the organic EL element with an acrylic transparent adhesive layer interposed therebetween in the same manner as in Example 1. Under these conditions, a voltage of 10 V was then applied to the organic EL element. As a result, current passed through the organic EL element on substantially the same order as mentioned in Example 1 to cause the emission of green electroluminescence from coumarine 6 as shown in Fig. 6. The brightness of the green electroluminescence was 141 cd/$m^2$.

A polarizing plate was then provided on the color conversion film of the present comparative example. As a result, the brightness was 61 cd/$m^2$. The brightness remained substantially the same when the polarizing plate was provided in any direction. It was thus made obvious that the planar light source according to the present comparative example emits unpolarized natural light.

<Comparative Example 2>

The procedure of the step (2) of preparing an anisotropic scattering color conversion layer of Example 1 was followed except that the liquid crystal polymer represented by the chemical formula (4) was not added and a 20 wt-% dichloromethane solution of 2 parts of 3-(2-benzothiazolyl)-7-diethylaminocoumarine (coumarine 6) represented by the chemical formula (5) was casted to form a film having a thickness of 100 μm which was then formed into a mere color conversion layer in the form of film without being stretched. Unlike the anisotropic scattering color conversion layer of Example 1 or the color conversion layer of Comparative Example 1, the color conversion layer thus prepared was a transparent film free from light scattering. The color conversion layer was then stuck to the glass substrate of the organic EL element with an acrylic transparent adhesive layer interposed therebetween in the same manner as in Example 1. Under these conditions, a voltage of 10 V was then applied to the organic EL element. As a result, current passed through the organic EL element on substantially the same order as mentioned in Example 1 to cause the emission of green electroluminescence from coumarine 6 as shown in Fig. 6. The brightness of the green electroluminescence was 103 cd/$m^2$.

A polarizing plate was then provided on the color conversion film of the present comparative example. As a result, the brightness was 44 cd/$m^2$. The brightness remained substantially the same when the polarizing plate was provided in any direction. It was thus made obvious that the planar light source according to the present comparative example emits unpolarized natural light.

<Comparative Example 3>

The procedure of the step (3) of Example 1 was followed except that the anisotropic scattering color conversion film was provided on the glass substrate of the organic EL element with an air layer interposed therebetween instead of acrylic transparent adhesive layer. Under these conditions, a voltage of 10 V was then applied to the organic EL element. As a result, current passed through the organic EL element on substantially the same order as mentioned in Example 1 to cause the emission of green electroluminescence from coumarine 6 as shown in Fig. 6. The brightness of the green electroluminescence was 85 cd/$m^2$.

A polarizing plate was then provided on the anisotropic scattering color conversion film thus prepared in such an arrangement that the stretching direction of the anisotropic scattering color conversion film and the transmission axis of the polarizing plate are parallel to each other in the same manner as in the step (4) of Example 1. A voltage of 10 V was then applied to the organic EL element. As a result, the brightness of the electroluminescence thus emitted was 61 cd/$m^2$. A sample obtained by providing the polarizing plate on the anisotropic scattering color conversion film in such an arrangement that the stretching direction of the anisotropic scattering color conversion film and the transmission axis of the polarizing plate are perpendicular to each other was then subjected to the same measurement as mentioned above. As a result, the brightness of the electroluminescence thus emitted was 26 cd/$m^2$. It was thus made obvious that the planar light source according to the present comparative example emits polarized light rich with a linearly polarized light component the electric field of which oscillates in the stretching direction of the anisotropic

scattering color conversion film.

<Example 2>

An anisotropic scattering film was prepared in the same manner as in the step (2) of preparing an anisotropic scattering color conversion layer of Example 1 except that 3-(2-benzothiazolyl)-7-diethylaminocoumarine (coumarine 6) represented by the chemical formula (5) was not added. Subsequently, the transparent color conversion film free from light scattering prepared in Comparative Example 2 was stuck to the glass substrate of an organic EL element prepared in the same manner as in Example 1 with an acrylic transparent adhesive layer interposed therebetween. The aforementioned anisotropic scattering film was then stuck to the aforementioned color conversion film with an acrylic transparent adhesive layer interposed therebetween.

Under these conditions, a voltage of 10 V was then applied to the organic EL element. As a result, current passed through the organic EL element on substantially the same order as mentioned in Example 1 to cause the emission of green electroluminescence from coumarine 6 as shown in Fig. 6. The brightness of the green electroluminescence was 140 cd/$m^2$.

A polarizing plate was then provided on the anisotropic scattering color conversion film thus prepared in such an arrangement that the stretching direction of the anisotropic scattering color conversion film and the transmission axis of the polarizing plate are parallel to each other in the same manner as in the step (4) of Example 1. A voltage of 10 V was then applied to the organic EL element. As a result, the brightness of the electroluminescence thus emitted was 78 cd/$m^2$. A sample obtained by providing the polarizing plate on the anisotropic scattering color conversion film in such an arrangement that the stretching direction of the anisotropic scattering color conversion film and the transmission axis of the polarizing plate are perpendicular to each other was then subjected to the same measurement as mentioned above. As a result, the brightness of the electroluminescence thus emitted was 52 cd/$m^2$. It was thus made obvious that the planar light source according to the present example emits polarized light rich with a linearly polarized light component the electric field of which oscillates in the stretching direction of the anisotropic scattering color conversion film.

<Evaluation>

Table 1 shows the characteristics of Examples and 2 and Comparative Examples 1 to 3. In Table 1, the term "stretching axis//transmission axis" indicates the brightness value of the arrangement having a polarizing plate provided on an anisotropic scattering color conversion film (or anisotropic scattering film) such that the stretching direction of the anisotropic scattering color conversion film and the transmission axis of the polarizing plate are parallel to each other and the term "stretching axis ⊥ transmission axis" indicates the brightness value of the arrangement having a polarizing plate provided on an anisotropic scattering color conversion film (or anisotropic scattering film) such that the stretching axis of the anisotropic scattering color conversion film and the transmission axis of the polarizing plate are perpendicular to each other. In the case of the unstretched arrangement which emits natural light (Comparative Examples 1 and 2), the brightness value of the arrangement having a polarizing plate provided thereon is used.

Table 1

| Sample | Applied voltage [V] | Current through element [mA] | Brightness [cd/m$^2$] | | |
|---|---|---|---|---|---|
| | | | Polarizing plate not provided | Polarizing plate provided | |
| | | | | Stretching axis // transmission axis | Stretching axis ⊥ transmission axis |
| Example 1 | 10 | 31.2 | 146 | 91 | 47 |
| Example 2 | | | 140 | 78 | 52 |
| Comparative Example 1 | | | 141 | 61 | |
| Comparative Example 2 | | | 103 | 44 | |
| Comparative Example 3 | | | 85 | 61 | 26 |

As can be seen in Table 1, the planar light source of Example 1 is arranged such that when excitation light (blue light) emitted by the light-emitting layer of the organic EL element is absorbed by coumarine 6 dispersed in the anisotropic scattering color conversion layer to cause the emission of fluorescence from coumarine 6, the guided component, which is inherently totally reflected, can be caught by the color conversion layer because no air layer is provided interposed between the light-emitting layer and the color conversion layer, making it possible to efficiently utilize excitation emitted by the organic EL element. Further, since coumarine 6 is dispersed in an anisotropic scattering resin layer, the externally emitted fluorescence is extracted as polarized light rich with a predetermined linearly polarized light component. Accordingly, in the case where the planar light source of Example 1 is used as a backlight for liquid crystal display device, the absorption loss in the polarizing plate can be reduced, making it possible to provide a high efficiency planar light source.

Similarly, the planar light source of Example 2 is found to have substantially the same effect as Example 1, though showing a slight drop of efficiency from Example 1.

On the contrary, the planar light source of Comparative Example 1, which comprises an unstretched color conversion film, shows scattering properties in the color conversion film but is not provided anisotropic scattering properties because it is free of microregions having different birefringence. As a result, it was made obvious that the comparative planar light source shows the same brightness value as Example 1 when it is free of polarizing plate, but when it is provided with a polarizing plate, the brightness value is halved because emission is absorbed by the polarizing plate by not smaller than 50%.

It is also made obvious that the planar light source of Comparative Example 2, which comprises a non-scattering transparent film as a color conversion layer, allows excitation light from the organic EL element to be caught by the color conversion layer, but fluorescence emitted by the color conversion layer is totally reflected before entering in the air layer, causing the drop of brightness value.

It is further made obvious that the planar light source of Comparative Example 3, which comprises an air layer interposed between an anisotropic scattering color conversion film and an organic EL element, can emit polarized light, but excitation light emitted by the organic EL element is totally reflected by the interface of the air layer rather than entering in the anisotropic scattering color conversion film and thus is lost as guided light, causing the drop of brightness value.

While Examples 1 and 2 have been described only with reference to green emission characteristic to coumarine 6, white emission can be given by properly adding several other light-emitting materials. In this case, too, the effect of the invention can be exerted.

The organic EL element prepared in Examples 1 and 2, i.e., blue light-emitting element used as an excitation light source does not necessarily have a high emission efficiency. As previously mentioned, however, when the efficiency of the excitation light source is enhanced by the use of a light-emitting material which utilizes triplet exciton to emit phosphorescence or a double heterostructure, the efficiency of the planar light source according to the invention can be accordingly enhanced.

As mentioned above, the planar light source according to the invention doesn't need to be provided with a

special light-emitting unit comprising microlens, reflecting dot, etc. as in the related art, making it possible to efficiently release light emitted in the anisotropic scattering color conversion layer (light-emitting material) by the incident excitation light to the exterior as linearly polarized light. This leads to an advantage that the operating voltage or current of the solid light-emitting element can be reduced; making it possible to drastically prolong the life of the element. Further, the polarization direction (oscillation plane) of linearly polarized light can be arbitrarily predetermined according to the angle at which the anisotropic scattering color conversion layer is arranged. Moreover, the color of linearly polarized light emitted to the exterior can be arbitrarily predetermined by properly selecting the light-emitting material.

Although the invention has been described in its preferred form with a certain degree of particularity, it is understood that the present disclosure of the preferred form can be changed in the details of construction and in the combination and arrangement of parts without departing from the spirit and the scope of the invention as hereinafter claimed.

**Claims**

**1.** A planar light source comprising:

a solid light-emitting element which emits light by electric energy; and
an anisotropic scattering color conversion layer formed on the light-emitting side of the solid light-emitting element with substantially no air layer interposed therebetween,
wherein the anisotropic scattering color conversion layer comprises a light-transmitting resin, a microregion dispersedly distributed in the light-transmitting resin having birefringence different from that of the light-transmitting resin and at least one light-emitting material incorporated in the light-transmitting resin and/or microregion, and
the light-transmitting material absorbs light emitted by the solid light-emitting element as excitation light to emit fluorescence or phosphorescence.

**2.** A planar light source according to claim 1, wherein the microregion is formed by a glass-state material obtained by cooling and fixing a liquid crystal phase or a liquid-crystalline material, or a material obtained by crosslinking and fixing the liquid crystal phase of a polymerizable liquid crystal with energy radiation.

**3.** A planar light source according to claim 1, wherein the microregion is formed by a liquid crystal polymer having a glass transition temperature of not lower than 50°C and shows nematic liquid crystal phase at a temperature lower than the glass transition temperature of the light-transmitting resin.

**4.** A planar light source according to claim 1, wherein the difference in refractive index between the microregion and the light-transmitting resin has the following relationships:

$$0.03 \leq \Delta n1 \leq 0.5$$

$$0 \leq \Delta n2 \leq 0.03$$

$$0 \leq \Delta n3 \leq 0.03$$

supposing that the maximum difference in refractive index along the axis of the microregion is $\Delta n1$ and the differences in refractive index in the direction perpendicular to the axis along which the maximum value is shown are $\Delta n2$ and $\Delta n3$.

**5.** A planar light source according to claim 1, wherein the solid light-emitting element is an organic electroluminescence element comprising at least one thin organic layer containing a light-transmitting layer formed between an anode and a cathode.

**6.** A display device comprising a planar light source according to claim 1.

**7.** A planar light source comprising:

a solid light-emitting element which emits light by electric energy;
an anisotropic scattering layer formed on the light-emitting side of the solid light-emitting element with substantially no air layer interposed therebetween; and
a color conversion layer comprising at least one light-transmitting material formed interposed between the solid light-emitting element and the anisotropic scattering layer,
wherein the anisotropic scattering layer comprises a light-transmitting resin and a microregion dispersedly distributed in the light-transmitting resin having birefringence different from that of the light-transmitting resin, and
the light-transmitting material absorbs light emitted by the solid light-emitting element as excitation light to emit fluorescence or phosphorescence.

**8.** A planar light source according to claim 7, wherein the microregion is formed by a glass-state material obtained by cooling and fixing a liquid crystal phase or a liquid-crystalline material, or a material obtained by crosslinking and fixing the liquid crystal phase of a polymerizable liquid crystal with energy radiation.

**9.** A planar light source according to claim 7, wherein the microregion is formed by a liquid crystal polymer having a glass transition temperature of not lower than 50°C and shows nematic liquid crystal phase at a temperature lower than the glass transition temperature of the light-transmitting resin.

**10.** A planar light source according to claim 7, wherein the difference in refractive index between the microregion and the light-transmitting resin has the following relationships:

$$0.03 \leq \Delta n1 \leq 0.5$$

$$0 \leq \Delta n2 \leq 0.03$$

$$0 \leq \Delta n3 \leq 0.03$$

supposing that the maximum difference in refractive index along the axis of the microregion is $\Delta n1$ and the differences in refractive index in the direction perpendicular to the axis along which the maximum value is shown are $\Delta n2$ and $\Delta n3$.

**11.** A planar light source according to claim 7, wherein the solid light-emitting element is an organic electroluminescence element comprising at least one thin organic layer containing a light-transmitting layer formed between an anode and a cathode.

**12.** A display device comprising a planar light source according to claim 7.

FIG. 1

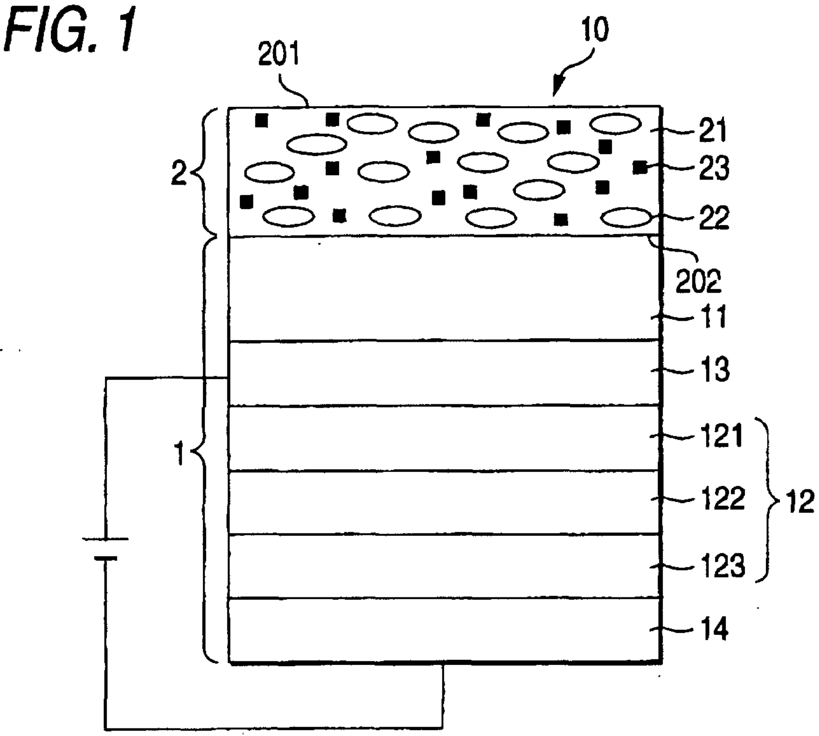
10
201
2
21
23
22
202
11
13
1
121
122
12
123
14

FIG. 2

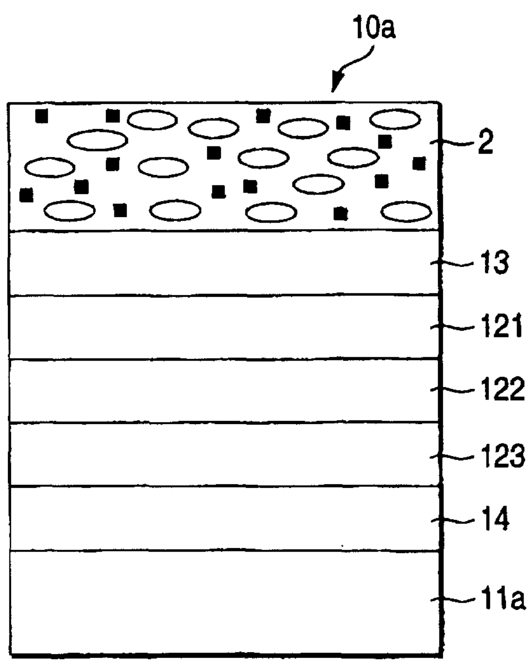
10a
2
13
121
122
123
14
11a

FIG. 3

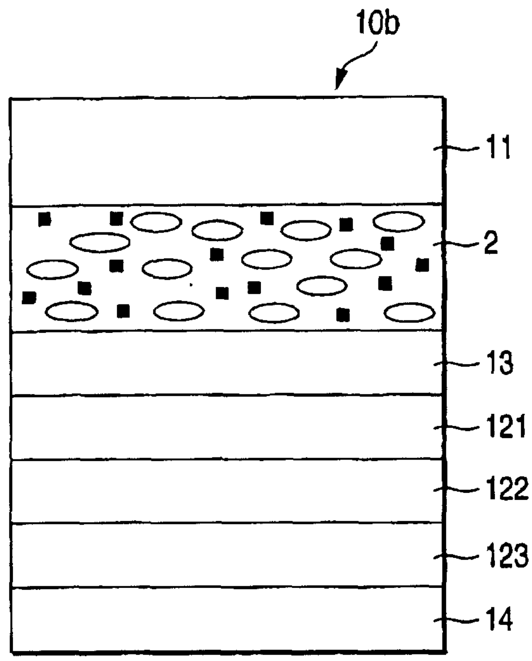


FIG. 4

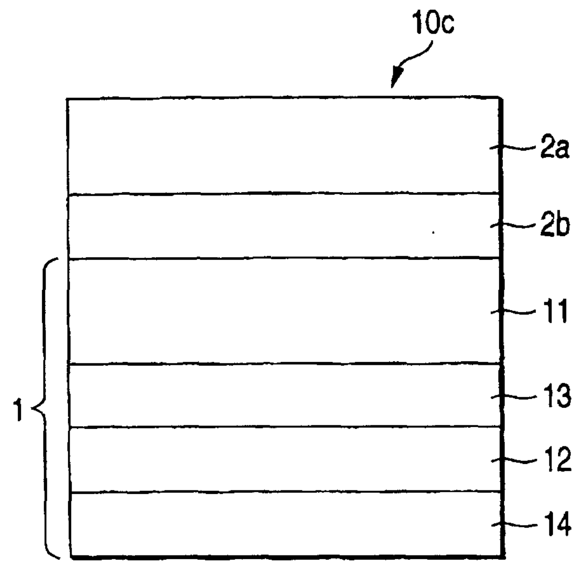

FIG. 5

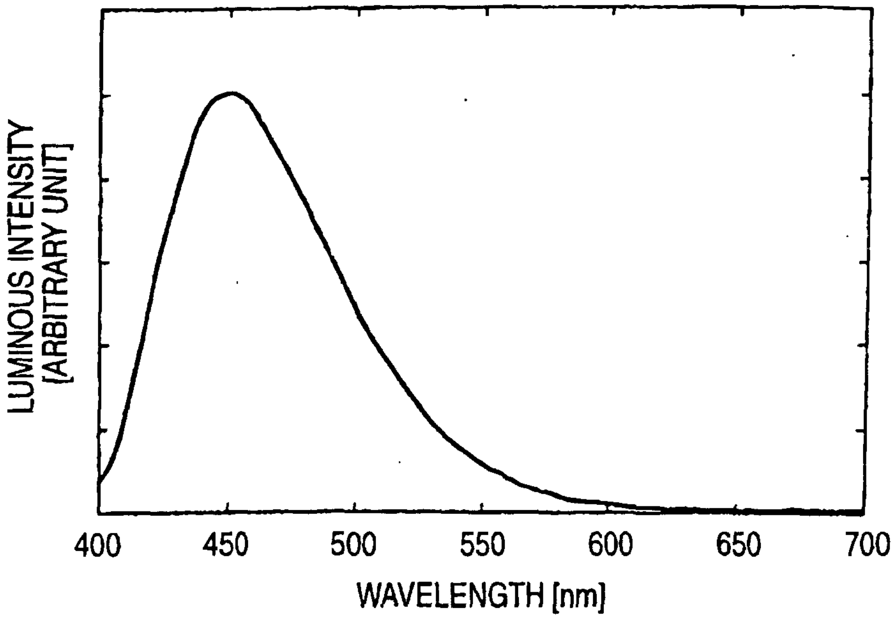
LUMINOUS INTENSITY
[ARBITRARY UNIT]
400
450
500
550
600
650
700
WAVELENGTH [nm]

FIG. 6

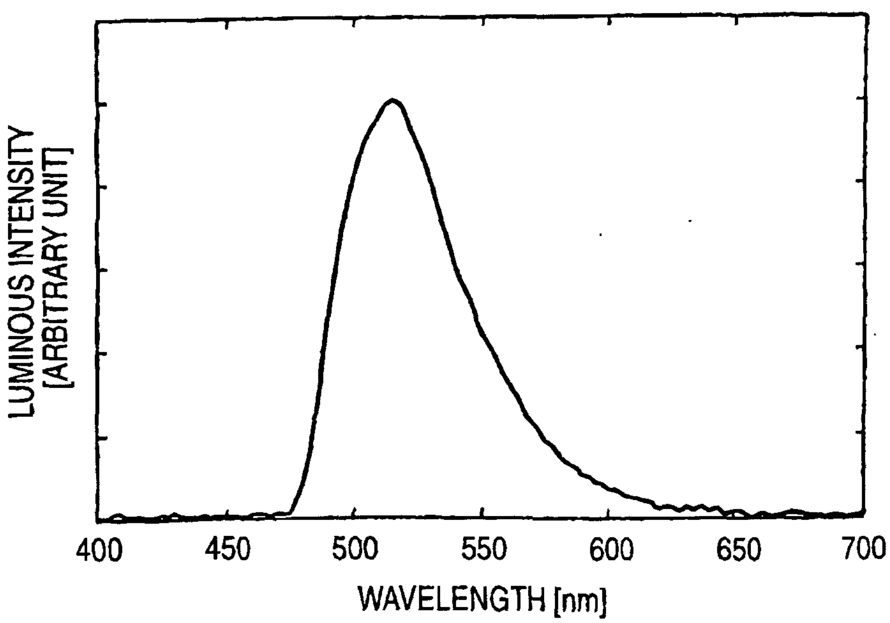
LUMINOUS INTENSITY
[ARBITRARY UNIT]
400
450
500
550
600
650
700
WAVELENGTH [nm]